# EUROPEAN PATENT APPLICATION

(11) **EP 4 325 883 A1**
(43) Date of publication of application: **21.02.2024**
(21) Application number: 23186278.0
(22) Date of filing: 19.07.2023
(51) Int. Cl.: H04Q 9/00, H01R 13/66

(54) **SMART POWER STRIP AND METHOD OF PLANT MONITORING CONTROL BASED ON THE SAME**

(30) Priority: 15.08.2022 CN 202210975627
(71) Applicant: Shenzhen Mei Zhi Guang Dian Limited, Shenzhen Guangdong 518115 (CN)
(72) Inventor: Hu, Dongwen, Shenzhen, 518100 (CN)
(74) Representative: Ipey

(57) **Abstract**

A smart power strip includes an output socket, sensor interface circuits, a communication control circuit; the communication control circuit is configured to acquire current environmental information monitored by the environmental monitors through the sensor interface circuits; the communication control circuit is further configured for interactive information with the intelligent communication terminal so as to send the current environmental information to the intelligent communication terminal. It is also achieved that the smart power strip is used as the main control device for the first time; because the power supply is an essential part of the plant monitoring process, by combining the power supply with control, it is not necessary to provide power supply independently, the convenience in the plant growth monitoring process is greatly improved to meet the use requirements of users and improve the efficiency of plant monitoring.

## Description

### FIELD OF THE INVENTION

The disclosure involves a technical field of a device for plant monitoring control, particularly, relates to a smart power strip and method of plant monitoring control based on the same.

### BACKGROUND OF THE INVENTION

Currently, plenty of monitoring control devices are generally used to monitor and control the growth of plants, each of the monitoring control devices uses a socket to supply power respectively. The monitoring control devices include various categories. For example, devices for light monitoring. Chinese Patent No. CN201810774698.0 discloses a kind of electronic ornament, vase thereof, electronic plant, illumination management system, and illumination supplementing method. The illumination management system comprises a processing unit, a monitoring unit, and a light supplementing unit. The monitoring unit is used for acquiring plant species information and plant lighting information, and the monitoring unit is communicatively connected to the processing unit.

Although the technical schemes disclosed in the above patent can achieve a controllable connection of the monitoring unit to the processing unit and can execute a light supplementing strategy to supplement light for the plant, the function thereof is single, and can only monitor and control the light in the plant growing process. If it is necessary to monitor and control other growth parameters, for example, to monitor the soil, it must additionally provide other monitoring control devices, for example, the intelligent control watering devices for plant biomimetic remediation of polluted soil disclosed in Chinese Patent No. CN201610841709.3. It, a plurality of monitoring devices combined to use, is a great disadvantage. Firstly it results in a great increasing cost in the production. secondly, since each of the monitoring devices is provided with an independent control part thereof respectively, a user has to operate different monitoring devices, respectively. This results in great inconvenience, and it easily causes the monitoring efficiency of a plant to be affected. And if the monitoring devices must be manually operated, the users have to operate them separately, which causes inconvenience in monitoring and control. In addition, each of the different monitoring control devices needs an independent socket for power supply, while currently, the socket on the market mostly has a single function, only supplying power, which cannot be smartly cooperated with various monitoring devices. Therefore, it affects the use of plant monitoring control devices, and further affects the plant monitoring control efficiency.

Thus, it is necessary to design a smart power strip and method of plant monitoring and control based on the same.

### SUMMARY OF THE INVENTION

The object of the disclosure is to provide a smart power strip and method of plant monitoring control based on the same, aiming to solve the technical problems in the prior art that various monitoring control devices are respectively used in a plant monitoring control process, however, each of the monitoring devices are operated separately, causing the higher cost, the inconvenience of operation, and each socket of the monitoring devices has a single function, only supplying power, which cannot be smartly cooperated with various monitoring control device, so that the requirements of the users cannot be met, thus, the plant monitoring control efficiency is affected.
For achieving the above object, the embodiments in the disclosure provide a smart power strip, which includes an output socket configured for connecting with an external power supply and environmental monitors, and supplying power to each of the environmental monitors; and the environmental monitors are configured to monitor current environmental information;
The smart power strip also includes sensor interface circuits connecting to the environmental monitors and a communication control circuit connecting to the sensor interface circuits, then the communication control circuit is configured to acquire current environmental information monitored by the environmental monitors through the sensor interface circuits;
The communication control circuit is further configured for interactive information with an intelligent communication terminal so as to send the current environmental information to the intelligent communication terminal;

The communication control circuit is further configured to receive environmental adjusting instruction sent by the intelligent communication terminal, and generate environmental control information based on the environmental adjusting instruction, and send the environmental control information to each of the environmental monitors through the sensor interface circuits, the environmental control information is used to control each of the environmental monitors.

Optionally, each of the sensor interface circuits comprises an identification end, an information receiving end, and a control end, all connected to the communication control circuit and the environmental monitors. After each of the environmental monitors is connected to the identification end and the control end of each of the sensor interface circuits, the communication control circuit identifies a sensor category of each of the environmental monitors through the identification end, acquires the current environmental information monitored by the environmental monitors connected to it through the information receiving end; the communication control circuit is further configured to send the environmental control information to the environmental monitors through the control end.

Optionally, the smart power strip also includes an electric metering circuit connected to the external power supply, and further connected to the communication control circuit; the communication control circuit is further configured to send a query command about electricity consumption to the electric metering circuit; and after receiving the query command about electricity consumption, the electric metering circuit generates practical electricity consumption information based on acquired practical power input by the external power supply, and sends it to the communication control circuit;

The communication control circuit receives the practical electricity consumption information and sends it to the intelligent communication terminal so that the intelligent communication terminal can display it.

Optionally, the smart power strip also includes a zero-crossing detection circuit and a switching power supply control circuit, wherein the zero-crossing detection circuit is connected to the communication control circuit and is configured to detect a zero voltage of the external power supply; the switching power supply control circuit is connected to both the communication control circuit and the output socket; and the communication control circuit is further configured to acquire the zero voltage detected by the zero-crossing detection circuit, generate a power supply signal, and send the power supply signal to the switching power supply control circuit so that the switching power supply control circuit controls, based on the power supply signal, the output socket to turn on when the voltage is zero.

Optionally, the smart power strip also includes a button start-stop circuit, which is connected to the communication control circuit. When the button start-stop circuit is triggered, the communication control circuit obtains a start-stop signal that triggers the button start-stop circuit, it generates a socket control signal, and sends the socket control signal to the switching power supply control circuit, the switching power supply control circuit controls, based on the socket control signal, the output socket to turn on when the voltage of the zero point is reached.
one or more technical solutions in the smart power strip provided in the embodiments according to the disclosure have at least one of the following technical effects:
Compared with the common power strip in the prior art, the smart power strip integrates sensor interface circuits for connecting the environmental monitors so that all of the environmental monitors can be connected to the sensor interface circuits in a unified way, so that the environmental monitors are not necessary to monitor separately, all of the environmental monitors, which work independently, are connected in series through the smart power strip, it is achieved that the current environmental information monitored in the plant growth process can be processed in a unified and centralized way through the communication control circuit, which can be achieved by only one of the smart power strip used as the main control device, so that the problem of higher cost caused by the fact that all monitoring devices in the prior art have control devices can be avoided, and information can be interacted with the smart power strip through intelligent communication terminal such as mobile phones, so that the users can send environmental adjusting instructions through the intelligent communication terminal. The smart power strip is used as the information receiving and transferring central to monitor and control all of the environmental monitors connected with the smart power strip, so as to realize unified monitoring and control in the plant growth process; in addition, it is also achieved that the smart power strip is used as the main control device for the first time. Because the power supply is an essential part of the plant monitoring control process, by combining power supply with control, it is not necessary to provide power supply independently, the convenience in the plant growth monitoring control process is greatly improved so as to meet the requirements of users and improve the efficiency of plant monitoring.

For achieving the above object, the disclosure also provides a method for plant monitoring control based on the smart power strip mentioned above, which includes the following steps:
step 100: the communication control circuit identifies a sensor category of each of the environmental monitors through the identification end of each of the sensor interface circuits;
step 200: the communication control circuit acquires the current environmental information monitored by the environmental monitors through the information receiving end of each of the sensor interface circuits;
step 300: the communication control circuit sends the current environmental information to the intelligent communication terminal so that the intelligent communication terminal can display it.

Optionally, the method for plant monitoring control based on the smart power strip also includes the following steps:
step 410: the intelligent communication terminal sends the environmental adjusting instruction to the communication control circuit so that the communication control circuit generates environmental control information based on the environmental adjusting instruction;
step 420: the communication control circuit sends the environmental control information to all of the environmental monitors through the sensor interface circuit. The environmental control information is used for adjusting all of the environmental monitors.

Optionally, the method for plant monitoring control plant based on the smart power strip further includes the following steps:
step 510: after the communication control circuit acquires a zero voltage detected by the zero-crossing detection circuit in the smart power strip, it generates a power supply signal;
step 520: the communication control circuit sends the power supply signal to the switching power supply control circuit in the smart power strip;
step 530: the switching power supply control circuit controls, based on the power supply signal, the output socket to turn on when the voltage is zero.

Optionally, the method for plant monitoring control based on the smart power strip also includes the following steps:
step 610: the communication control circuit sends the query command about electricity consumption to the electric metering circuit;
step 620: after receiving the query command about electricity consumption, the electric metering circuit generates the practical electricity consumption information based on acquired practical power input by the external power supply, and sends it to the communication control circuit;
step 630: after the communication control circuit receives the practical electricity consumption information, sends it to the intelligent communication terminal, so that the intelligent communication terminal can display it.

For achieving the above object, the disclosure also provides a method for plant monitoring control based on the smart power strip and the intelligent communication terminal mentioned above, which includes the following steps:
step 710: the communication control circuit identifies a sensor category of the environmental monitors based on the identification end of each of the sensor interface circuits;
step 720: the communication control circuit acquires the current environmental information monitored by the environment monitors through the information receiving end of each of the sensor interface circuits;
step 730: the communication control circuit sends the current environmental information to the intelligent communication terminal;
step 740: the intelligent communication terminal displays the current environmental information.
one or more technical solutions in the method for monitoring and controlling the plant based on the smart power strip provided in the embodiments according to the disclosure have at least one of the following technical effects:
In the method for monitoring and controlling the plant based on the smart power strip, firstly the communication control circuit identifies a sensor category of the environmental monitors based on the identification end of each of the sensor interface circuits; then, the communication control circuit acquires the current environmental information monitored by the environment monitors through the information receiving end of each of the sensor interface circuits; and, the communication control circuit sends the current environmental information to the intelligent communication terminal so that the intelligent communication terminal displays the current environmental information, thus the environmental monitors are not necessary to monitor separately, all of the environmental monitors, which work independently, are connected in series through the smart power strip, it is achieved that the current environmental information monitored in the plant production process can be processed in a unified and centralized way through the communication control circuit. It is also achieved that the smart power strip is used as the main control device for the first time. Because the e power supply is an essential part of the plant monitoring process, by combining power supply with control, it is not necessary to provide power supply independently, the convenience in the plant growth monitoring process is greatly improved so as to meet the requirements of the users and improve the efficiency of plant monitoring.

### BRIEF DESCRIPTION OF THE DRAWINGS

In order to more clearly illustrate the technical schemes in the embodiments in the disclosure, the drawings needed in the embodiments or the prior technical description are briefly introduced below. Obviously, the drawings described below are only some embodiments in the disclosure, and for those skilled in the art, additional drawings may be obtained according to the drawings below without creative work.
Fig. 1 is a perspective view of the smart power strip provided in the embodiment according to the disclosure.
Fig. 2 is a flowchart of the method for plant monitoring control provided in the embodiment according to the disclosure.
Fig. 3 is a flowchart of adjusting all of the environmental monitors provided in the embodiment according to the disclosure.
Fig. 4 is a flowchart of turning on the output socket provided in the embodiment according to the disclosure.
Fig. 5 is a flowchart displaying the practical electricity consumption information provided in the embodiment according to the disclosure.
Fig. 6 is a flowchart in that the intelligent communication terminal displays the current environment information provided in the embodiment according to the disclosure.

### DETAILED DESCRIPTION OF ILLUSTRATED EMBODIMENTS

The embodiments of the disclosure will be described in detail below. Examples of the embodiments are shown in the drawings, where the same or similar reference numerals throughout indicate the same or similar elements or elements having the same or similar functions. The embodiments described below by referring to the accompanying drawings are exemplary and are intended to be used to explain the embodiments of the disclosure, but cannot be understood as limiting the disclosure.

In the description of the embodiment of the disclosure, it needs to be understood that the azimuth or position relation indicated in the terms "length "," width "," upper "," lower "," front "," rear "," left"," right "," vertical "," horizontal "," top "," bottom" inside "," outside "and so on are based on the azimuth or position relation shown in the attached drawing, only for the convenience of describing the embodiment of the disclosure and simplifying the description, rather than indicating or implying that the device or element must have a specific orientation, with a specific orientation and operation, so it can not be understood as a limitation to the disclosure.

Furthermore, the terms "first " and "second" are used only for descriptive purposes and they can not be understood as indicating or implying relative importance or implicitly the number of technical features indicated. Thus, the qualification of "first" and "second" features may include one or more of them explicitly or implicitly. In the description of the embodiments of the invention, the meaning of "multiple" is two or more, unless otherwise specified.

In the embodiment of the invention, unless other specified and qualified, the terms "installation "," connection "," fixed" and other terms shall be broadly understood, for example, it may be fixed connection, detachable connection, or integration; it may be a mechanical connection or an electrical connection; it may be directly connected or indirectly connected by intermediate media, it may be an internal connection of two components or the interaction of two components. For ordinary technicians in the field, the specific meaning of the above term in the embodiment of the invention can be understood according to the specific circumstances.

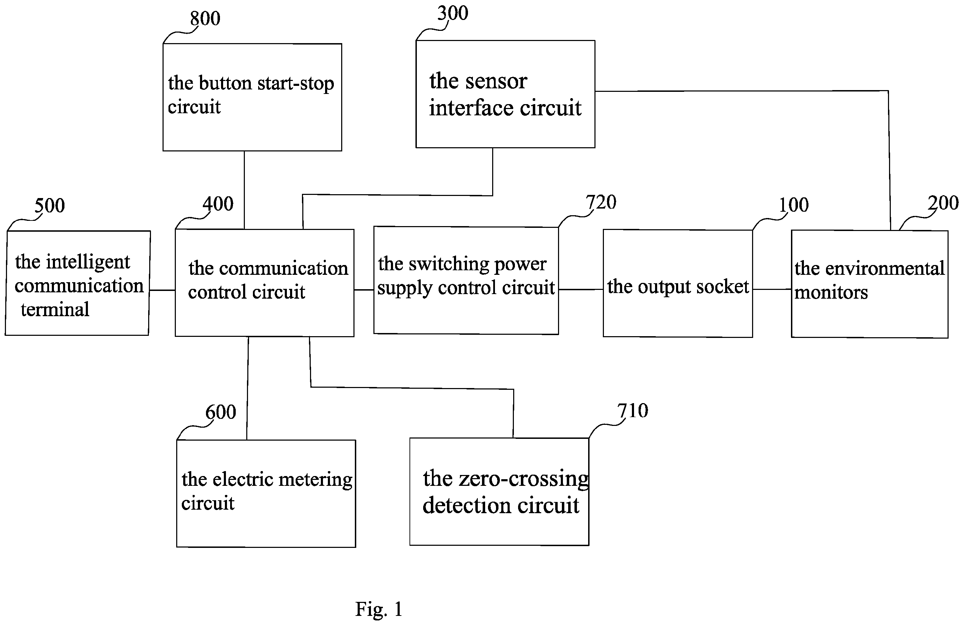

In the embodiment according to the disclosure, referring to Fig. 1, the smart power strip includes an output socket 100 used for connecting with an external power supply and connecting with environmental monitors 200 and supplying power to each of the environmental monitors 200; and the environmental monitors 200 are used for monitoring current environmental information.

The environmental monitors 200 includes but is not limit to various sensors, such as temperature sensors, humidity sensors, dimmers, heating pads, carbon dioxide detection sensors, cameras, and the like, so that the environmental monitors 200 can obtain the information such as temperature, humidity, carbon dioxide concentration, images and the like, and dimming and control of the heating pad can also be realized.

The smart power strip also includes plenty of sensor interface circuits 300 connecting to the environmental monitors 200, a communication control circuit 400 connecting to the sensor interface circuits 300, and the communication control circuit 400 is used for acquiring the current environmental information monitored by the environmental monitors 200 through the sensor interface circuits 300.

The communication control circuit 400 is further used for interactive information with the intelligent communication terminal 500 so as to send the current environmental information to the intelligent communication terminal 500. The intelligent communication terminal 500 includes but is not limited to electronic devices such as mobile phones, tablets, and other computers, or the like, as long as it can achieve information regulation with the communication control circuit 400.

Further, the information interaction method between the communication control circuit 400 and the intelligent communication terminal 500 includes, but is not limited to, Bluetooth and Wifi.

The communication control circuit 400 is further configured to receive environmental adjusting instruction sent by an intelligent communication terminal 500, generate environmental control information based on the environmental adjusting instruction, and send the environmental control information to each of the environmental monitors 200 through the sensor interface circuits 300, the environmental control information is used to control each of the environmental monitors 200. Wherein, the environmental control information is a specific sensor parameter set on the intelligent communication terminal 500 by the user, for example, increasing lighting, then, the communication control circuit 400 generates the environmental control information based on the environmental adjusting instruction, and the environmental control information is an instruction based on the environmental adjusting instruction, and used to regulate the environmental monitors 200 and make each of the environmental monitors 200 perform actions matching the environmental adjusting instruction.

Compared with the common power strip in the prior art, the smart power strip in the disclosure integrates the sensor interface circuits 300 for connecting the environmental monitors 200, so that all of the environmental monitors 200 can be connected to the sensor interface circuits 300 in a unified way so that the environmental monitors 200 are not necessary to monitor respectively, all of the environmental monitors 200, which work independently, are connected in series through the smart power strip, it is achieved that the current environmental information monitored in the plant growth process can be processed in a unified and centralized way through the communication control circuit 400, which can be achieved by only one of the smart power strip used as the main control device so that the problem of high cost caused by the fact that all monitoring devices in the prior art have control devices respectively can be avoided, and the users can use intelligent communication terminals 500 such as mobile phones to perform information interaction with the smart power strip so that the users can send the environmental adjusting instruction through the intelligent communication terminals 500, and the smart power strip is used as the information receiving and transferring central to regulate all of the environmental monitors 200 connected with the smart power strip, so as to realize unified regulation and control of the plant growth process. In addition, it is also achieved that the smart power strip is used as the main control device for the first time. Because the power supply is an essential part in the plant monitoring control process, by combining power supply with control, it is not necessary to provide the power supply separately, the convenience in the plant growth monitoring process is greatly improved so as to meet the requirements of the users and improve the efficiency of plant monitoring.

In another embodiment in the disclosure, each of the sensor interface circuits 300 comprises an identification end, an information receiving end, and a control end.

The identification end, the information receiving end, and the control end are all connected to the communication control circuit 400, and are all further connected to the environmental monitors 200; after the environmental monitors 200 are connected to the identification end and the control end, the communication control circuit 400 identifies a sensor category of each of the environmental monitors 200 through the identification end, acquires the current environmental information monitored by each of the environmental monitors 200 connected with it through the information receiving end; the communication control circuit 400 is further configured to send the environmental control information to each of the environmental monitors 200 through the control end.

Further, before the identification end identifies various of the environmental monitors 200, it first identifies the frequency of each of the environmental monitors 200 and stores it as a specific frequency corresponding to each of the environmental monitors 200, so that each of the environmental monitors 200 corresponds to a specific frequency. When each of the environmental monitors 200 is connected to the sensor interface circuits 300, the communication control circuit 400 identifies a sensor category of each of the environmental monitors 200 connected with it based on the specific frequency through the identification end, thus, the communication control circuit 400 learns the specific category of each of the environmental monitors 200 connected with it. After the communication control circuit 400 sends the sensor category to the intelligent communication terminal 500, the corresponding environmental monitors 200 will be displayed on the intelligent communication terminal 500, thereby achieving a visual display of each of the environmental monitors 200, for the convenience of users to individually or uniformly regulate each of the environmental monitors 200.

In another embodiment, it may set a specific label on each of the environmental monitors 200 in advance so that each of the environmental monitors 200 corresponds to the specific label. When each of the environmental monitors 200 is connected to the sensor interface circuits 300, the communication control circuit 400 identifies the sensor category of the environmental monitoring device 200 connected with it based on the specific label through the identification end.

In another embodiment, referring to Fig. 1, the smart power strip also includes an electric metering circuit 600 connected to an external power supply, and further connected to the communication control circuit 400; the communication control circuit 400 is further configured for sending a query command about electricity consumption to the electric metering circuit 600; and after receiving the query command about electricity consumption, the electric metering circuit 600 generates practical electricity consumption information based on the practical power input by the external power supply, and sending it to the communication control circuit 400.

After the communication control circuit 400 receives the practical electricity consumption information, sends it to the intelligent communication terminal 500 so that the intelligent communication terminal 500 can display it. Thus, by setting the electric metering circuit 600, it is possible for the users to timely obtain the practical electricity consumption information of each of the environmental monitors 200, thereby realizing the regulation timely.

In another embodiment, referring to Fig. 1, the smart power strip also includes a zero-crossing detection circuit 710 and a switching power supply control circuit 720, wherein the zero-crossing detection circuit 710 is connected to the communication control circuit 400 and is used for detecting a zero voltage of the external power supply; the switching power supply control circuit 720 is connected to both the communication control circuit 400 and the output socket 100; and the communication control circuit 400 is further configured to acquire a zero-crossing voltage detected by the zero-crossing detection circuit 710, generate a power supply signal, and send the power supply signal to the switching power supply control circuit 720 so that the switching power supply control circuit 720 controls, based on the power supply signal, the output socket 100 to turn on the output socket when the voltage is zero.

In the embodiment, the switching power supply control circuit 720 includes multiple relays (not shown in the figure), each of which is connected to a contact point within the output socket 100. When a relay is controlled to close, the corresponding contact point of the relay is powered on, which can then be used to supply power to external devices.

Further, in the embodiment, the external power supply is an alternating current, taking mains power as an example, there is a voltage of 0 in a conversion process of a positive waveform and a negative waveform, namely, the zero point voltage in the disclosure, when the output socket 100 is opened at the zero point voltage, specifically, closing a relay at the zero point voltage, the damage to the relay is reduced to the maximum extent. Compared with the prior art that the replay is controlled to be closed when is powered on, it is easily generated in spark and caused damage to it, the disclosure greatly improves the safety during relay control based on the zero-crossing detection circuit 710, also greatly prolongs the service life of the relay, thereby indirectly improving the service life of the smart power strip.

In another embodiment, referring to Fig. 1, the smart power strip also includes a button start-stop circuit 800, which is connected to the communication control circuit 400. When the button start-stop circuit 800 is triggered, after the communication control circuit 400 obtains a start-stop signal that triggers the button start-stop circuit 800, it generates a socket control signal and sends the socket control signal to the switching power supply control circuit 720, the switching power supply control circuit 720 controls, based on the socket control signal, the output socket 100 to turn on when the voltage of the zero point is reached.

In the embodiment, the button start-stop circuit 800 includes multiple buttons (not shown in the figure), which are triggered to set the power supply or not for the contact points in the output socket 100, thereby improving convenience during use.

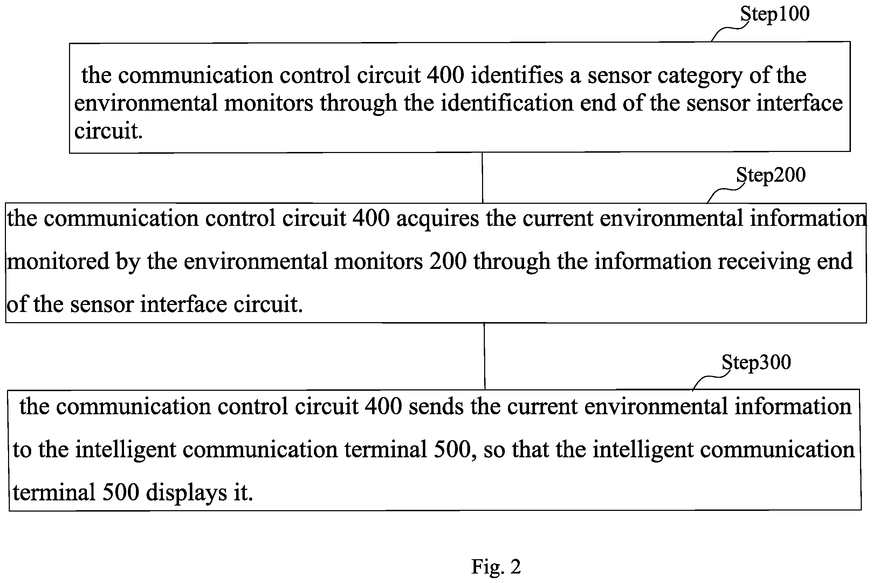

In another embodiment, referring to Fig. 2, the disclosure also provides a method for plant monitoring control based on the smart power strip, which includes the following steps:
step 100: the communication control circuit 400 identifies a sensor category of the environmental monitors through the identification end of each of the sensor interface circuits;
step 200: the communication control circuit 400 acquires the current environmental information monitored by the environmental monitors 200 through the information receiving end of each of the sensor interface circuits 300;
step 300: the communication control circuit 400 sends the current environmental information to the intelligent communication terminal 500 so that the intelligent communication terminal 500 can display it.

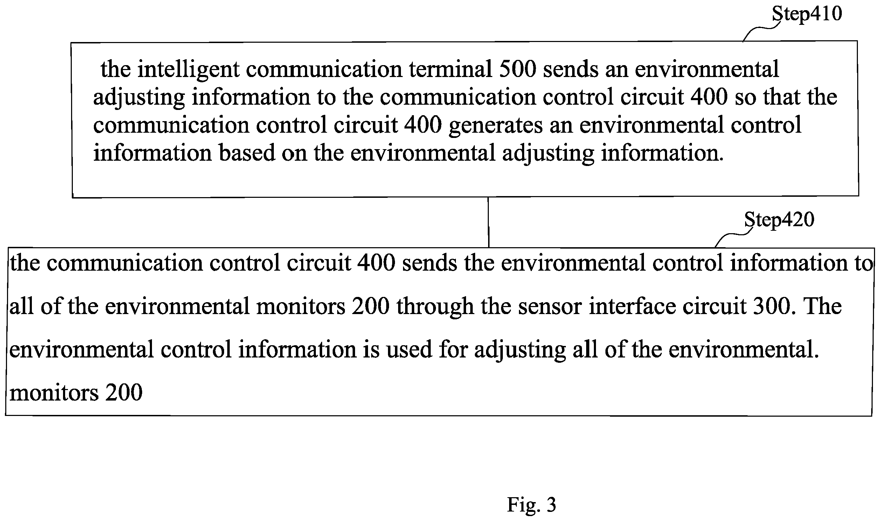

In another embodiment, referring to Fig. 3, the method for plant monitoring control based on the smart power strip also includes the following steps:
step 410: the intelligent communication terminal 500 sends environmental adjusting instruction to the communication control circuit 400 so that the communication control circuit 400 generates environmental control information based on the environmental adjusting instruction;
step 420: the communication control circuit 400 sends the environmental control information to all of the environmental monitors 200 through the sensor interface circuits 300. The environmental control information is used for adjusting all of the environmental monitors 200.

In the method for plant monitoring control based on the smart power strip, firstly the communication control circuit 400 identifies a sensor category of the environmental monitors 200 based on the identification end of each of the sensor interface circuits 300; then, the communication control circuit 400 acquires the current environmental information monitored by the environmental monitors 200 through the information receiving end of each of the sensor interface circuits 300; and, the communication control circuit 400 sends the current environmental information to the intelligent communication terminal 500 so that the intelligent communication terminal 500 displays the current environmental information, thus the environmental monitors 200 are not necessary to monitor respectively, all of the environmental monitors 200, which work independently, are connected in series through the smart power strip, it is achieved that the current environmental information monitored in the plant production process can be processed in a unified and centralized way through the communication control circuit 400.

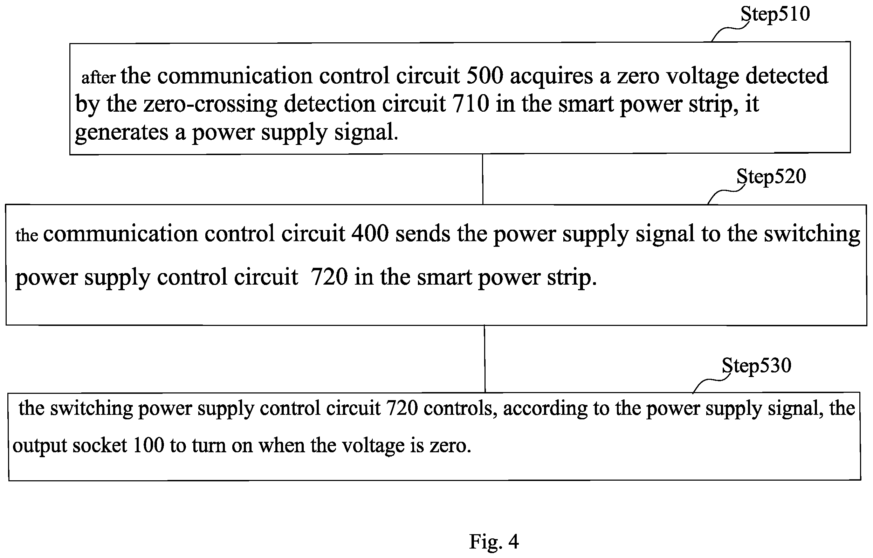

In another embodiment, referring to Fig. 4, the method for plant monitoring control based on the smart power strip also includes the following steps:
step 510: after the communication control circuit 400 acquires a zero voltage detected by the zero-crossing detection circuit 710 in the smart power strip, it generates a power supply signal;
step 520: the communication control circuit 400 sends the power supply signal to the switching power supply control circuit 720 in the smart power strip;
step 530: the switching power supply control circuit 720 controls, based on the power supply signal, the output socket 100 to turn on when the voltage is zero.

Further, the switching power supply control circuit 720 controls the output socket 100 to turn on when the voltage is zero based on the power supply signal, thereby avoiding the problems of sparks and damage to the relay caused by controlling the relay to close when the relay is powered on in the existing technology, greatly improving the safety of the relay control process and greatly improving the service life of the relay, Thereby indirectly improving the service life of the smart power strip.

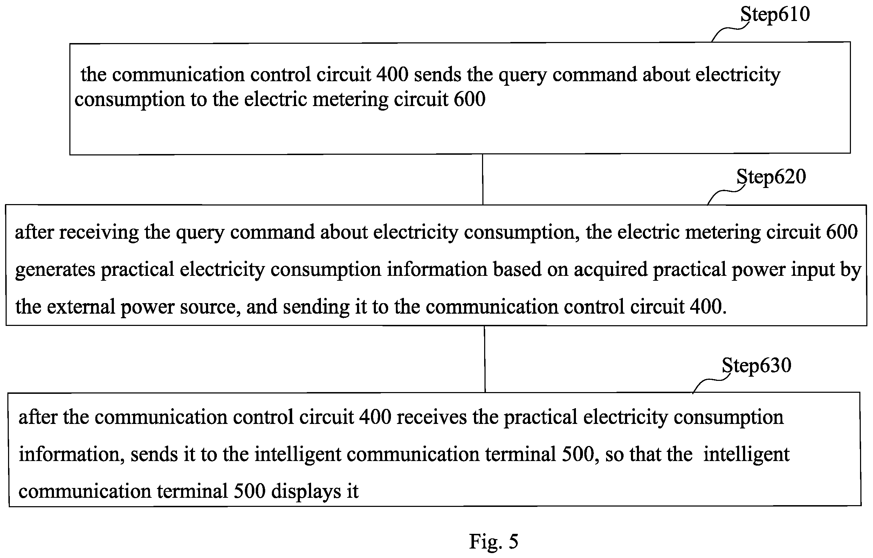

In another embodiment, referring to Fig. 5, the method for plant monitoring control based on the smart power strip also includes the following steps:
step 610: the communication control circuit 400 sends the query command about electricity consumption to the electric metering circuit 600;
step 620: after receiving the query command about electricity consumption, the electric metering circuit 600 generates the practical electricity consumption information based on acquired practical power input by the external power supply and sends it to the communication control circuit 400;
step 630: after the communication control circuit 400 receives the practical electricity consumption information, sends it to the intelligent communication terminal 500 so that the intelligent communication terminal 500 can display it.

Further, after the electric metering circuit 600 receives the query command about electricity consumption, it generates the practical electricity consumption information based on the practical power input by the external power supply and sends the practical electricity consumption information to the communication control circuit 400; then the communication control circuit 400 receives the practical electricity consumption information and sends it to the intelligent communication terminal 500 so that the intelligent communication terminal 500 can display it, thereby realizing on-demand statistics and display of electricity consumption.

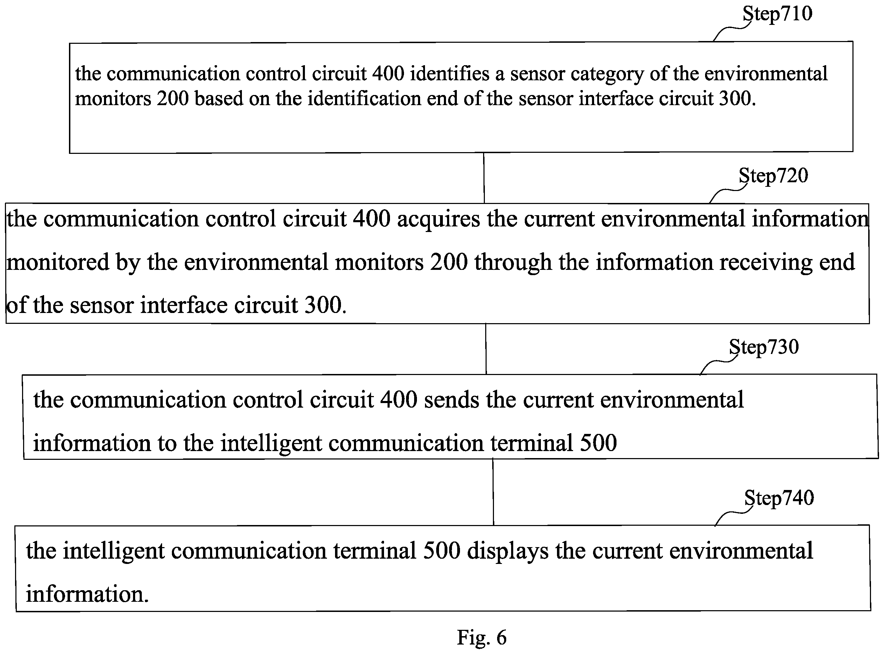

In another embodiment, referring to Fig. 6, the method for plant monitoring control based on the smart power strip also includes the following steps:
step 710: the communication control circuit 400 identifies a sensor category of the environmental monitors 200 based on the identification end of each of the sensor interface circuits 300;
step 720: the communication control circuit 400 acquires the current environmental information monitored by the environmental monitors 200 through the information receiving end of each of the sensor interface circuits 300;
step 730: the communication control circuit 400 sends the current environmental information to the intelligent communication terminal 500;
step 740: the intelligent communication terminal 500 displays the current environmental information.

The above is only a preferred embodiment of the disclosure and is not intended to limit it. Any modifications, equivalent substitutions, and improvements made within the spirit and principles of the present disclosure shall be included in the scope of protection of the disclosure.

## Claims

1. A smart power strip, comprising an output socket connecting with an external power supply and environmental monitors, and supplying power to each of said environmental monitors; and said environmental monitors are configured to monitor current environmental information, wherein, also comprising:
sensor interface circuits, connecting to said environmental monitors;
a communication control circuit, connecting to said sensor interface circuits, and configured to acquire said current environmental information monitored by said environmental monitors through said sensor interface circuits;
said communication control circuit is further configured for interactive information with said intelligent communication terminal so as to send said current environmental information to said intelligent communication terminal;
said communication control circuit is further configured to receive environmental adjusting instruction sent by an intelligent communication terminal, generate environmental control information based on said environmental adjusting instruction, and send said environmental control information to each of said environmental monitors through each of said sensor interface circuits, said environmental control information is used to control each of said environmental monitors.

2. The smart power strip according to claim 1, wherein each of said sensor interface circuits comprises an identification end, an information receiving end, and a control end, all connected to said communication control circuit and said environmental monitors; after said environmental monitors are connected to said identification end and said control end, said communication control circuit identifies a sensor category of each of said environmental monitors through said identification end, acquires said current environmental information monitored by said environmental monitors connected to it through said information receiving end; said communication control circuit is further configured to send said environmental control information to said environmental monitors through said control end.

3. The smart power strip according to claim 1, wherein said smart power strip also comprising an electric metering circuit connected to an external power supply and said communication control circuit; said communication control circuit is configured to send query command about electricity consumption to said electric metering circuit; and after receiving said query command about electricity consumption, said electric metering circuit generates practical electricity consumption information based on practical power input by said external power supply and sends said practical electricity consumption information to said communication control circuit;
said communication control circuit receives said practical electricity consumption information and sends it to said intelligent communication terminal so that said intelligent communication terminal can display it.

4. The smart power strip according to claim 1, wherein said smart power strip also comprising a zero-crossing detection circuit and a switching power supply control circuit, wherein said zero-crossing detection circuit is connected to said communication control circuit and is configured for detecting a zero voltage of said external power supply; said switching power supply control circuit is connected to both said communication control circuit and said output socket; and said communication control circuit is further configured to acquire said zero voltage detected by said zero-crossing detection circuit, generate a power supply signal and send said power supply signal to said switching power supply control circuit so that said switching power supply control circuit controls said output socket to turn on when said voltage is zero based on said power supply signal.

5. The smart power strip according to claim 4, wherein said smart power strip also comprising a button start-stop circuit connected to said communication control circuit; when said button start-stop circuit is triggered, said communication control circuit obtains a start-stop signal that triggers said button start-stop circuit, generates a socket control signal and sends it to said switching power supply control circuit; said switching power supply control circuit controls said output socket to turn on when said voltage is zero based on said socket control signal.

6. A method for plant monitoring control based on said smart power strip according to claim 1, wherein comprising following steps:
step 100: said communication control circuit identifies a sensor category of each of said environmental monitors through an identification end of said sensor interface circuit;
step 200: said communication control circuit acquires said current environmental information monitored by said environmental monitors through said information receiving end of said sensor interface circuit;
step 300: said communication control circuit sends said current environmental information to said intelligent communication terminal so that said intelligent communication terminal can display it.

7. The method for plant monitoring control based on said smart power strip according to claim 6, wherein also comprises following steps:
step 410: said intelligent communication terminal sends said environmental adjusting instruction to said communication control circuit so that said communication control circuit generates environmental control information based on said environmental adjusting instruction;
step 420: said communication control circuit sends said environmental control information to all of said environmental monitors through said sensor interface circuit; said environmental control information is configured to adjust all of said environmental monitors.

8. The method for plant monitoring control based on said smart power strip according to claim 6, wherein also comprises said following steps:
step 510: after said communication control circuit acquires a zero voltage detected by said zero-crossing detection circuit, it generates a power supply signal;
step 520: said communication control circuit sends said power supply signal to said switching power supply control circuit;
step 530: said switching power supply control circuit controls said output socket to turn on when said voltage is zero based on said power supply signal.

9. The method for plant monitoring control based on said smart power strip according to claim 6, wherein also comprises following steps:
step 610: said communication control circuit sends said query command about electricity consumption to said electric metering circuit;
step 620: after receiving said query command about electricity consumption, said electric metering circuit generates practical electricity consumption information based on acquired practical power input by said external power supply, and sends it to said communication control circuit;
step 630: after said communication control circuit receives said practical electricity consumption information, sends it to said intelligent communication terminal so that said intelligent communication terminal can display it.

10. A method for plant monitoring control based on said smart power strip according to any of claim 1-5, wherein comprising following steps:
step 710: said communication control circuit identifies a sensor category of said environmental monitors based on said identification end of said sensor interface circuit;
step 720: said communication control circuit acquires said current environmental information monitored by said environment monitoring device through said information receiving end of said sensor interface circuit;
step 730: said communication control circuit sends said current environmental information to said intelligent communication terminal;
step 740: said intelligent communication terminal displays said current environmental information.
